(19) Europäisches Patentamt
European Patent Office
Office européen des brevets

(11) **EP 1 739 055 A1**

(12) **EUROPEAN PATENT APPLICATION**

(43) Date of publication:
**03.01.2007 Bulletin 2007/01**

(51) Int Cl.:
**B81C 5/00** (2006.01)

(21) Application number: **05106029.1**

(22) Date of filing: **01.07.2005**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(71) Applicant: **Agilent Technologies, Inc.**
**Palo Alto, CA 94306 (US)**

(72) Inventor: **Falk-Jordan, Stefan**
**76187, Karlsruhe (DE)**

(74) Representative: **Barth, Daniel Mathias et al**
**c/o Agilent Technologies Deutschland GmbH,**
**Patentabteilung,**
**Herrenbergerstrasse 130**
**71034 Böblingen (DE)**

(54) **Substrate with geometrical test structures**

(57)    A product (100) comprising a substrate (101) and a plurality of test structures (102) formed in and/or on a surface (103) of the substrate (101), wherein the test structures (102) are positioned in such a predefined spatial relation with respect to each other to be indicative of the geometrical properties of the product (100).

**Fig. 1**

EP 1 739 055 A1

# Description

BACKGROUND ART

In microstructure technology applications including the formation of miniaturized channels, it should be reliably ensured that the quality and the geometrical characteristics of such channels fulfil predetermined specifications. In applications in which two substrates are connected by bonding, a proper alignment of the two substrates with respect to each other should be guaranteed. Generally in microstructure technology, a product can only provide its functional capabilities when structures formed on or in a substrate of such a product have geometrical parameters which are within a predetermined range of tolerances. For instance, the width of a channel of a gel electrophoresis device should differ from a predetermined target value only within a predetermined range of tolerances.

In order to control or verify the quality of a chip, it may be necessary to check whether a channel geometry is in accordance with particular specifications. In a scenario in which two substrates are bonded with one another, it may be necessary to check whether structures formed in an upper substrate and structures formed in a lower substrate are in proper alignment relative to each other.

Conventionally, geometrical properties of such structures are monitored by means of a complicate measurement technique. For instance, the width of a channel of a gel electrophoresis device is analyzed quantitatively by means of an expensive high-quality microscope with additional measurement equipment. This procedure is time-consuming. The conventional methods involve significant additional costs since it may be necessary for an engineer to manually check the geometrical parameters of the channels before accepting or rejecting the product as in accordance or as not in accordance with the geometrical requirements.

DISCLOSURE

It is an object of the invention to allow an inspection of geometrical properties of a product.

This object may be solved by a product, by a fluid separation system, by a system for inspecting a product, by a method of inspecting a product, and by a reticle according to the independent claims. Exemplary embodiments are shown by the dependent claims.

According to an exemplary embodiment of the invention, a product is provided comprising a substrate (for instance a glass substrate or a semiconductor substrate), a plurality of test structures (for instance recesses, projections, or colour markers) formed in and/or on a surface of the substrate, wherein the test structures may be positioned in such a predefined spatial relation with respect to each other to be indicative of the geometrical properties of the product.

According to another exemplary embodiment of the invention, a fluid separation system (for instance a gel electrophoresis device or a liquid chromatography device) for separating compounds of a fluid is provided, comprising a separation unit adapted for separating compounds of the fluid, wherein the separation unit comprises a product having the above-mentioned features.

According to another exemplary embodiment of the invention, a system (for instance an apparatus) for inspecting a product (for instance a product having the above-mentioned features) is provided, the system comprising a structure forming unit (for instance a lithography apparatus and an etching apparatus) for forming a plurality of test structures in and/or on a surface of a substrate of the product and for positioning the test structures in a predefined spatial relation with respect to each other. Furthermore, the system may comprise an inspection unit (a magnifier or a simple microscope) for inspecting the geometrical properties of the product under consideration of the predefined spatial relation of the test structures.

According to yet another exemplary embodiment of the invention, a method of inspecting a product is provided, comprising the steps of forming (including for instance a lithography step and an etching step) a plurality of test structures in and/or on a surface of a substrate of the product, positioning the test structures in a predefined spatial relation with respect to each other, and inspecting (for instance by means of a magnifier or a simple microscope) the geometrical properties of the product under consideration of the predefined spatial relation.

According to still another exemplary embodiment of the invention, a reticle (that is to say a mask) is provided comprising a base member (for instance opaque or transparent) and a plurality of (for instance transparent or opaque) test features formed in and/or on the base member. The test features may be positioned in such a predefined spatial relation with respect to each other to be indicative of the geometrical properties of test structures of a product having the above-mentioned features manufactured by means of the reticle.

According to an embodiment of the invention, test structures are formed in a portion of a substrate which is not needed for forming functional structures. The test structures may be aligned with respect to each other so that it is possible, for instance by an optical inspection of the test structures, to derive the geometrical properties of the product or to verify that geometrical properties meet the specifications.

For instance, the test structures may be arranged in groups of individual test structures, wherein the test structures of a group may have a pre-known distance from one another. A characteristic broadening of the test structures, for instance induced by an etching process, results in a characteristic width of the test structures. The width of the test structures may be correlated to the width of functional structures, in case that test structures and functional structures are manufactured simultaneously in a common manufacturing step. Thus, an analysis of the geometrical properties of the test structures (which may be specially adapted to the test purpose) may allow to derive information concerning the geometrical properties of the functional structures. Particularly, the alignment of the test structures with respect to each other may allow to determine the width of the functional structures.

For instance, the test structures of a group of test structures may have a distance with respect to each other which is pre-known or may be indicated (for instance by means of providing a corresponding number assigned to a group) on a substrate on or in which the test structures are formed. Such a distance may be, for instance, in the order of magnitude of an expected width of the test structures and of the functional structures.

For a particular group, central portions of the test structures may have a particular distance from each other which exactly equals to twice of the width of the test structures. Consequently, a portion between the test structures of this group is bridged or bypassed due to the broadening of the test structures. For groups for which central portions of the test structures have a larger distance from each other, a web or wall remains between the broadened test structures. For groups for which central portions of the test structures have a smaller distance from each other, the broadened test structures are also bridged. By inspecting which of the groups have bridged test structures and which of the groups have non-bridged test structures, and by taking into account the different pre-known distances between the test structures of the different groups, the width of the test structures can be derived. According to an embodiment of the invention, test structures may be formed in two opposing substrates to be bonded (for instance by means of pressure and/or thermal energy) so as to form the product. The alignment of test structures in the first substrates with test structures in the second substrates can be verified by inspecting the orientation of the test structures in the two substrates relative to each other. A proper alignment can be detected by means of a corresponding overlap of the test structures of the two substrates.

Since, according to an embodiment of the invention, the test structures can be manufactured without additional costs, preferably simultaneously with forming the functional structures, there are no additional costs for providing the test structures, since test structures and functional structures can be formed based on a single common reticle.

The verification of the geometrical properties can be performed at one or more particular positions of a wafer, or even on the basis of a chip for controlling the quality of each individual chip manufactured based on a wafer.

Furthermore, the inspection of a product according to an embodiment of the invention can be performed with a simple magnifier and without any particular skills so that it is possible to determine the geometrical properties of the product with low effort.

According to an embodiment of the invention, alignment markers with integrated measurement positions are provided.

On an etching structure's side of a substrate, a crossing, a circle or the like may be etched as a test structure for aligning the corresponding bonding plate to the functional structures etched therein. The opposing part or substrate may then have corresponding markings or holes as test structures.

An advantage of such a method may be that, as a result of the high accuracy of a mask patterning process (for instance tolerances of about 1 nm to 5 nm and less), the geometrical relation between functional structures and these markers or test structures may be extremely good. The same may be valid for the opposing side or substrate. Using a power blast method, an accuracy of few micrometers and less may be obtained.

In order not to have only a single structure for aligning the wafers, the alignment markers may include measurement markers. Such measurement markers may be provided at a pre-known distance from one another, so that the alignment between the two wafers to be bonded may be determined quantitatively with high accuracy. In combination with a circular test structure on the other wafer (as an alternative to a circle, other geometrical configurations are possible), it may be possible to measure the alignment concerning quality and quantity without an additional measurement device. In case that a circle formed in the upper substrate is not symmetrical to markers provided at a predetermined distance from one another on the lower substrate, a defocusing distance can be recognized by simply inspecting the relation between markers and circle. For instance, it is possible to select the distance of the markers at one fourth of the specified accuracy for the alignment process.

According to another exemplary embodiment of the invention, a direct or quasi-direct measurement of the width of the channels, and an indirect measurement of the depth of the channels is possible.

When the etch ratio between the etching direction in a horizontal and in a vertical direction of the etching method is known, this information can be used for the estimation of the depth and the width of an etching trench as a channel. The width of the channel of an etched structure can be calculated as the sum of the width in the mask plus two times the product of the etching depth and the etching ratio. For instance, when the width of the mask is 10 $\mu$m, the etching ratio is 1:1,2 and the desired depth is 15 $\mu$m, this results in a width of the channel of 46 $\mu$m.

Thus, an embodiment of the invention may allow to measure the width of a formed channel in a quasi-direct manner. For this purpose, the (in many cases) reasonable assumption may be made that the channel width of the mask/reticle is correct, with a sufficient accuracy (of, for instance, 1 nm to 3 nm). In such a scenario, as described above, the channel width may be determined by adding two times the measured value of the structure. This may have the advantage that, for a chip having channels with different widths, it may be dispensible to map each single of the channels in a test structure. It may be sufficient to consider merely the eventually different etching depths.

For the measurement of the channel width and depth, a number of groups of two parallel aligned test structures can be produced by means of the mask layout, wherein the two parallel aligned test structures have a distance from one another of two times the product of the etching depth and the etching ratio. In this context, the etching depth is varied in an appropriate range around a target etching depth, for instance in steps of one fourth of an allowed tolerance as a minimal increment. This is based on the assumption that the tolerance of the reticle is in the range of 1 nm to 5 nm and is thus much smaller than the required tolerance of the channel structure which shall be measured by this method.

According to an exemplary embodiment of the invention, a glass chip with quantitative process control marks is provided. This may simply improve the manufacturing process control, concerning estimation of etch width and layer alignment. Thus, an obtained pattern after etching may serve as a reference for the etch width.

According to an embodiment of the invention, patterns on opposing substrates to be bonded to one another may by qualitatively or quantitatively aligned.

For instance, glass chips having channels may be used for electrophoresis experiments and devices. For this purpose, channels may be etched in a glass chip or a glass wafer with a width of for instance 30 $\mu$m to 200 $\mu$m, and with a depth of, for instance, 8$\mu$m to 25 $\mu$m. Then, a second glass chip may be provided with through holes as contact channels. The second substrate may be bonded to the first substrate so that the through holes in the second substrate match with the channels in the first substrate allow to introduce material in the channels of the first substrate by inserting this material in the through holes.

For a gel electrophoresis experiment, gel material and an analyte may be introduced through the through holes into the channels. The success of such an experiment requires an accurate knowledge of the geometrical parameters characterizing the channels and requires a proper alignment of the upper and lower substrate so that an end portion of the through hole in the upper substrate contacts a channel of the lower substrate. In the context of a manufacture of such a glass chip, embodiments of the invention provide a cheap control mechanism for verifying the etching width/etching depth of the channels and/or the through holes.

According to an aspect of the invention, a structure is provided in a glass chip, and test channels may be applied at a predetermined distance from one another on and/or in the substrate. These test channels may be characterized optically by means of a magnifier or a simple microscope, or by a corresponding machine, for instance a micro-scanner scanning the test recessed.

The channels in the substrate may be manufactured by means of illuminating the substrate covered with a photoresist, by selectively removing the illuminated portions (or the non-illuminated portions) of the photoresist layer on the substrate by etching, and by removing material of uncovered regions of the glass chip by means of a suitable etching process (for instance chemical etching, wet etching, dry etching, plasma etching, laser etching or the like). Thus, a combination of an optical lithography step and an etching step may be used for forming test structures and, if desired, of functional structures. During an etching process as described, the mask structures transformed to the photoresist are broadened in the substrates by effects like underetching/undercutting.

By inspecting groups of test structures, particular test recesses, the width of the test structures and thus of the correspondingly formed functional structures can be estimated directly or at least quasi-directly, and their depths can be estimated indirectly. The latter indirect information can be derived from the fact that the physics of the etch method results in a characteristic and predictable ratio of width and depth of the etched structure. For instance, when performing a chemical etching method using hydrofluoric acid (HF), this etching method involves a characteristic ratio of an isotropic and anisotropic etching components or, in other words, a characteristic amount of underetching. When a structure with a particular width is formed with this special etching method, it may be possible to theoretically or empirically calculate or evaluate with sufficient precision the width of the etched structures based on the knowledge of the width of the structure.

The substrates to be processed or investigated according to an embodiment of the invention may be glass substrates like a round or quadratic glass wafer with linear dimensions of, for instance, 4 inch or 8 inch. Such a wafer may be divided into a plurality of chips having, for instance, a rectangular shape with a linear dimension in the range between, for instance, 17.4 mm and 57 mm.

Test structures and functional structures (or use structures) may be manufactured on one and the same wafer or chip, and test structures and functional structures may be formed in one and the same method step so that the etching characteristic during the manufacture of the test structures also applies for the etching characteristic and manufacture of the functional structures. This may allow for a meaningful quality control of the product formed.

Thus, according to one embodiment of the invention, test structures may be formed in addition to functional structures, wherein the additional structures allow to verify the alignment or dimensioning of the functional structures without the necessity to provide any additional equipment. Thus, it is possible to verify the geometrical quality of a product.

Exemplary technical application fields of the system according to the invention are products for electrophoresis devices (performing an electrical separation of components of an analyte) or other analysis devices, for instance separating components of an analyte by means of pressure-induced separation of an analyte in a channel. Furthermore, the system according to the invention may be used in frame of a lab-on-chip.

According to an exemplary embodiment of the invention, the system may be applied to an integrated circuit formed in a semiconductor substrate, for instance in a silicon chip. Also in this context, it is possible to provide test structures and to determine geometric information concerning functional structures in an integrated circuit (for instance the gate length of a MOSFET) by means of inspecting the spatial relation between test structures (for instance test trenches formed in the semiconductor substrate). For ensuring a proper quality of an integrated semiconductor circuit, an accurate knowledge of the geometrical properties of the integrated circuit components is required. For instance, the gate length of a MOSFET transistor has a significant and sensitive influence to the electrical properties of the MOSFET.

In the following, further exemplary embodiments of the product will be described. However, these embodiments also apply to the fluid separation system, for the system for inspecting a product, for the method of inspecting a product, and for the reticle. According to embodiments of the invention, it may be possible to inspect geometrical properties of the product in a quantitative or in a qualitative manner.

The substrate may be a microstructure substrate. In other words, the product may be manufactured based on microstructure technology.

The test structures may be positioned in such a predefined spatial relation with respect to each other to be quantitatively indicative of the geometrical properties of the product. Since it is possible to provide the test structures or markers at a predefined and varying distance from one another, quantitative information concerning the geometrical properties may be determined based on an analysis of the test structures (for instance whether they are bridged or non-bridged, particular by analyzing a border between bridged and non-bridged test structures).

The test structures may be test recesses or trenches. Alternatively, the test structures may be test projections or color markers. It is also possible that the test structures are magnetic markers, radioactive markers or the like.

The substrate may be a glass substrate or a semiconductor substrate. However, the invention is not restricted to these materials and may also be used with substrates of other materials, for instance a ceramic substrate or a plastic substrate. When using a semiconductor substrate, this can be made from silicon, germanium, or a group III - group V semiconductor, like gallium arsenide.

The substrate may be a wafer (comprising a plurality of chips) or may be a chip (for instance manufactured by separating individual chips from a wafer). Thus, the invention may be applied on chip level or on wafer level.

In particular, the substrate may be a wafer being divided into a plurality of chips, and the test structures may be formed in and/or on at least one of the group consisting of a peripheral region of the wafer outside of the chips, a region between adjacent chips, and the chips. By locating test structures in regions of the wafer which are not occupied by chips, it is possible to provide the test structures in "unused" portions of the wafer, so that expensive silicon or glass wafers can be used more efficiently. However, it is also possible to provide the test structures directly on the chips which may allow to localize problematic portions of a wafer, in which portions manufacturing problems are cumulated. For instance, the chips of a wafer may be numbered, and if problems at particular chips occur, it can be determined whether this is a problem of an individual wafer or whether a plurality of wafers of a lot show problems at particular chips located at corresponding geometrical positions with respect to the wafer.

The product may comprise functional structures formed in and/or on the surface of the substrate. The functional structures may be adapted to provide the actual function of the product. The term "functional structures" may particularly denote structures which are used for fulfilling an aimed function which the product shall offer. In the context of a glass chip for gel electrophoresis, the functional structures may be channels which are then filled with gel and analyte material during practical use. In the context of a semiconductor chip, the functional structures may be, for instance, MOSFETs or other integrated circuit components formed in the semiconductor chip, which will then be used as memory cells, switches, or the like. In contrast to the functional structures, the test structures may not have a particularly assigned function during practical use of the product, but may have their main or predominant function in supporting the inspection of the geometrical properties of the product.

For instance, the functional structures may be adapted as channels of a fluid separation device. Such a fluid separation device may be a gel electrophoresis device or a liquid chromatography device, for instance an HPLC (High Performance Liquid Chromatography).

Particularly, the functional structures may also be functional recesses, for instance channels of a fluid separation device, or trenches etched during a semiconductor process for forming, for instance, vertical transistors or buried integrated circuit members. Or, the functional recesses may be channels for a biochip. However, the functional structures may also be projections, color markers, magnetic structures or radioactive structures.

The test structures may be positioned in such a predefined spatial relation with respect to each other to be indicative of the width and/or of the depth of the test structures. Particularly, the width may be measured quasi-directly, the depth may be determined based on a theoretical or an empirical knowledge of a correlation between the width and the depth.

The test structures may be grouped so that in different groups, the corresponding test structures may have different distances from one another. For instance, each group may comprise two test recesses formed as to parallel aligned elongated holes, wherein the distance between the elongated holes differs from group to group, for instance in a monotonic manner (i.e. increasing or decreasing continuously from group to group). A border between groups of bridged and non-bridged test recesses may then allow a determination of the width of the structures.

The test structures may also be grouped so that, in adjacent groups, the corresponding test structures have varying distances from each other.

Particularly, the test structures may be grouped so that, in adjacent groups, the corresponding test structures may have incremental distances from each other. For instance, from group to group, the distance may be increased with an increment of, for instance, 0.25 $\mu$m or 1 $\mu$m.

The test structures may comprise at least one of the group consisting of essentially parallel aligned elongated holes or essentially parallel aligned elongated webs, concentric circular rings, circles positioned at a distance from one another, concentric polygonal rings, and polygons positioned at a distance from one another. However, the mentioned shapes are merely exemplary, other shapes may be used as well.

The test structures may be positioned in such a predefined spatial relation with respect to each other to be indicative of an alignment between the substrate and a further substrate bonded with or to be bonded with the substrate. According to this embodiment, the alignment between the two substrates to be connected may be ensured allowing to improve the reliability of the proper function of the product.

The test structures may be positioned in such a predefined spatial relation with respect to each other to be indicative of an alignment with further test structures formed in a further substrate bonded with or to be bonded with the substrate.

The test structures may be groups of items arranged equidistantly from one another. By taking this measure, quantitative markers may be provided to ensure the proper alignment of the two substrates to be bonded.

The items may comprise at least one of the group consisting of elongated holes, elongated projections, circular rings, circles, and polygons. The further test structures may be at least one of the group consisting of a circle, a polygon, and a crossing. However, the product according to embodiments of the invention is not restricted to these exemplary geometrical configurations.

The product according to the invention may be realized as microfluidic product, that is to say a product having microchannels into which a fluid or a gel may be introduced. "Microfluidics" may particularly be denoted as the science of designing, manufacturing, and formulating devices and processes that deal with volumes of fluid on the order of microlitres, nanoliters or picoliters. Such devices themselves may particularly have dimensions ranging from centimeters, millimeters down to micrometers.

Particularly, the product may be one of the group consisting of a fluid separation product, a gel electrophoresis product or a liquid chromatography product. The product according to embodiments of the invention may be adapted as a device for chemical, biological and/or pharmaceutical analysis, and may include a separation system adapted for separating compounds of a sample. Exemplary application fields of the product according to embodiments of the invention are mass spectroscopy, liquid chromatography, capillary electrophoresis, bioanalysis.

In the following, further exemplary embodiments of the fluid separation system according to an exemplary embodiment of the invention will be described. However, these embodiments also apply for the product, for the system for inspecting a product, for the method of inspecting a product, and for the reticle.

The fluid separation system may comprise a fluid delivering unit for delivering the fluid. Such a fluid delivering unit may comprise containers containing educt fluids and a transport system for transporting the fluid(s) through the channels of a fluid separation system to the separation unit. Separated components may be provided in other containers. The fluid may be insertable in the functional structures.

BRIEF DESCRIPTION OF DRAWINGS

Objects and many of the attendant advantages of embodiments of the present invention will be readily appreciated and become better understood by reference to the following more detailed description of embodiments in connection with the accompanied drawings. Features that are substantially or functionally equal or similar will be referred to by the same reference signs.

Fig. 1 to Fig. 3 show a product according to an exemplary embodiment of the invention.

Fig. 4 shows a product according to another exemplary embodiment of the invention.

Fig. 5A to Fig. 5C show different layer sequences during a method of manufacturing a product according to an exemplary embodiment of the invention.

Fig. 6A and Fig. 6B show a plan view of test structures and illustrate a principle for deriving structural information based on an analysis of the arrangement of the test structures.

Fig. 7 illustrates test recesses arranged in a predefined spatial relation with respect to each other in order to allow a quantitative analysis of geometrical properties of a product.

Fig. 8 shows a detailed view of a portion of Fig.

7.

Fig. 9 shows a product according to an exemplary embodiment of the invention.

Fig. 10A, Fig. 10B show exemplary test structures.

Fig. 11 shows a lithography apparatus including a reticle according to an exemplary embodiment of the invention.

The illustration in the drawing is schematically.

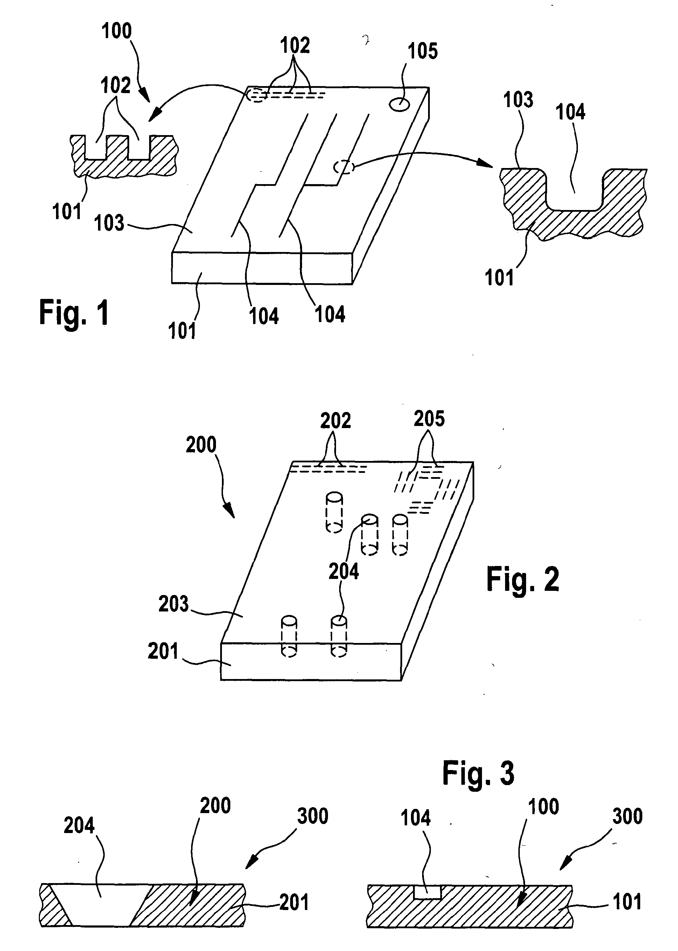

In the following, referring to **Fig. 1,** a product 100 according to an exemplary embodiment of the invention will be described.

The product 100 comprises a glass substrate 101 and a plurality of test recesses 102 formed in a surface 103 of the glass substrate 101. The test recesses 102 are positioned in such a predefined spatial relation with respect to each other to be indicative of the geometrical properties of the product 100.

Furthermore, the product 100 comprises a plurality of functional channel structures 104 adapted to provide a function of the product 100. Since the product 100 is a part of a fluid separation device, the functional structures 104 serve as channels of this fluid separation device, by which channels gel material may be received and via which channels an analyte solution may be transported by means of an applied electric field.

A detailed view in Fig. 1 shows an enlarged sectional view of one of the functional channels 104. Another detailed view in Fig. 1 shows an enlarged sectional view of two of the test recesses 102.

As can be further seen in Fig. 1, a circular recess 105 having an annulus shape is formed in another surface 103 region of the product 100.

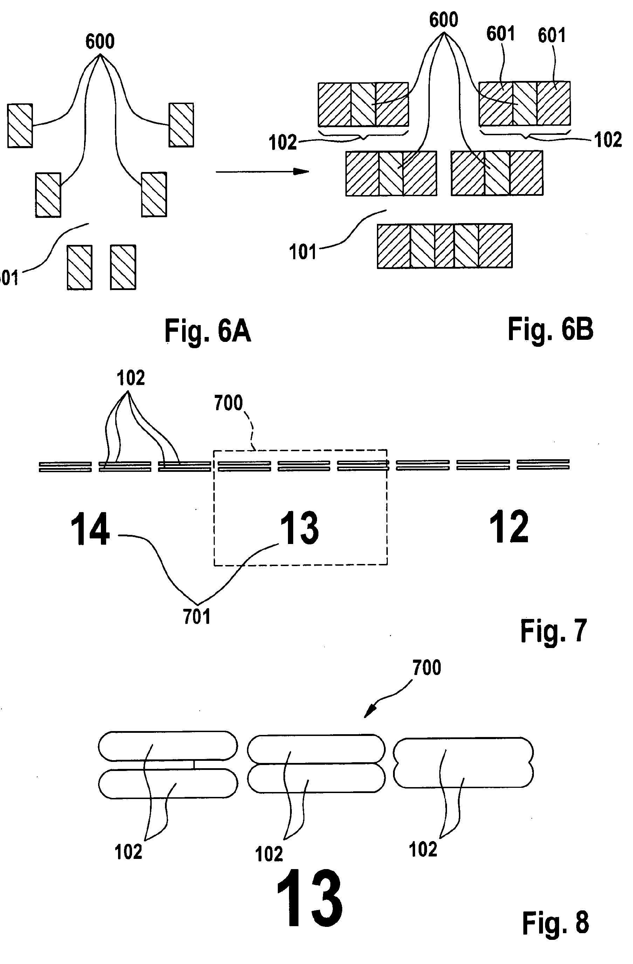

The test recesses 102 are positioned in such a predefined spatial relation with each other to be indicative of the width and/or of the depth of the test structures 102. Particularly, the test recesses 102 are grouped pairwise so that in different pairs, the corresponding test recesses 102 have different distances from each other. This will be described in more detail referring to Fig. 7 and Fig. 8.

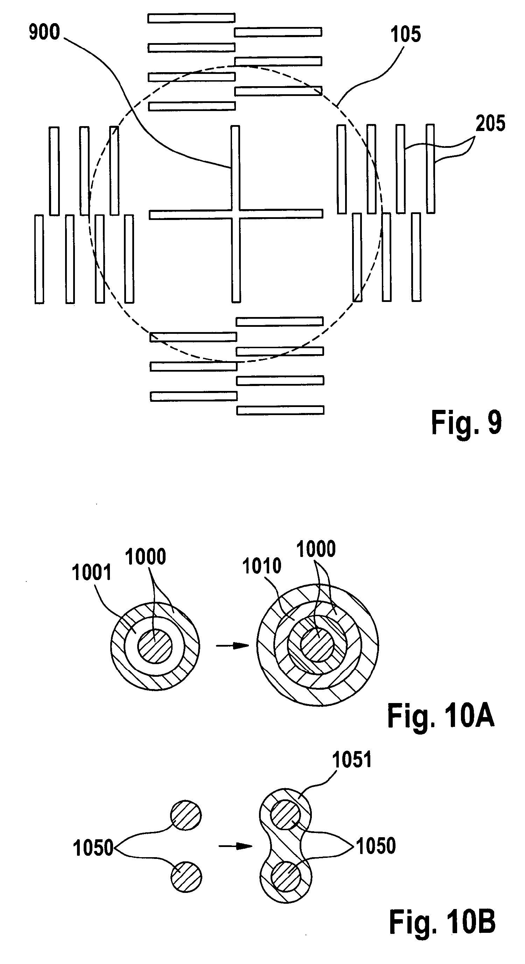

The function of the circular channel 105 will also be described below, particularly referring to Fig. 9.

In the following, referring to **Fig. 2,** a product 200 according to an exemplary embodiment of the invention will be described.

The product 200 comprises a glass substrate 201, wherein a plurality of test recesses 202 are formed in a surface 203 of the glass substrate 201. The test recesses 202 are positioned in such a predefined spatial relation with respect to each other to be indicative of the geometrical properties of the product 200. Furthermore, functional through holes 204 are provided at particular positions of the surface 203 of the glass substrate 201.

Since for instance the product 100 and the product 200 are adapted to be bonded together to form a chip for a gel electrophoresis device, the through holes 204 are provided as injection channels for injecting fluid, gel, analyte, etc., wherein this fluid is intended to be transported through the through holes 204 into the channels 104 of Fig. 1.

This intended function has the consequence that two requirements are to be fulfilled by the through holes 204. Firstly, the width of the circular surface portion of the through holes 204 should be within particular tolerances to allow a proper injection of fluid, gel or the like. Secondly, the positions of the through holes 204 should be such that, after having bonded the product 100 to the product 200, the through holes 204 are in alignment with the channels 104 so that fluid inserted in the through holes 204 can be transported in the channels 104.

For the first purpose, namely to ensure that the geometrical parameters defining the through holes 204 are within predefined tolerances, the test recesses 202 are provided on the surface 203 of the glass substrate 201. The detailed function of these channels will be explained below referring to Fig. 7, Fig. 8.

For ensuring the second above condition, namely a proper alignment of the channels 104 and the through holes 204, alignment recesses 205 are formed in the surface 203 of the second product 200 and being in such a predefined spatial relation with respect to each other to be indicative of an alignment between the alignment recesses 205 and the circular channel 105 formed in the first product 100. Such an alignment may be achieved when the first product 100 is bonded to the second product 200.

It should be noted that the test recesses 102, the circular channel recesses 105, the test recesses 202 and the alignment recesses 205 may be formed by means of a photolithography and an etching process as it is well known, as such, from the prior art.

It is important to note that the manufacture of the test recesses 102 and of the circular test channel 105 as well as of the channels 104 may occur in one and the same simultaneous lithography and etching step. Thus, when a mask or reticle is used for forming recesses 102, 104, 105, the spatial relation and the manufacture conditions for the recesses 102, 104, 105 are properly defined and are automatically correlated for all structures 102, 104, 105. Consequently, the width of the etching structures 102 are correlated to the width of the etching structures 104. Further, the geometrical alignment between the circular test channel 105 and the functional channels 104 is also properly defined.

The same is valid for the relation between the dimensions of the test recesses 202 and the through holes 204, and for the relative geometric arrangement between the alignment recesses 205 and the through holes 204.

**Fig. 3** shows a cross-sectional view of the second product 200 and of the first product 100 which may be bonded together to form a glass chip for gel electrophoresis.

The cross-sectional view 300 shows that it is necessary that the through hole 204 formed in the second product 200 is brought in proper alignment with the channels 104 formed in the surface of the first product 100. This is necessary to ensure that material filled in the through holes 204 is injected in the channels 104. For this purpose, the test recesses 105, 205 are provided which will be described in more detail below referring to Fig. 7 to Fig. 9.

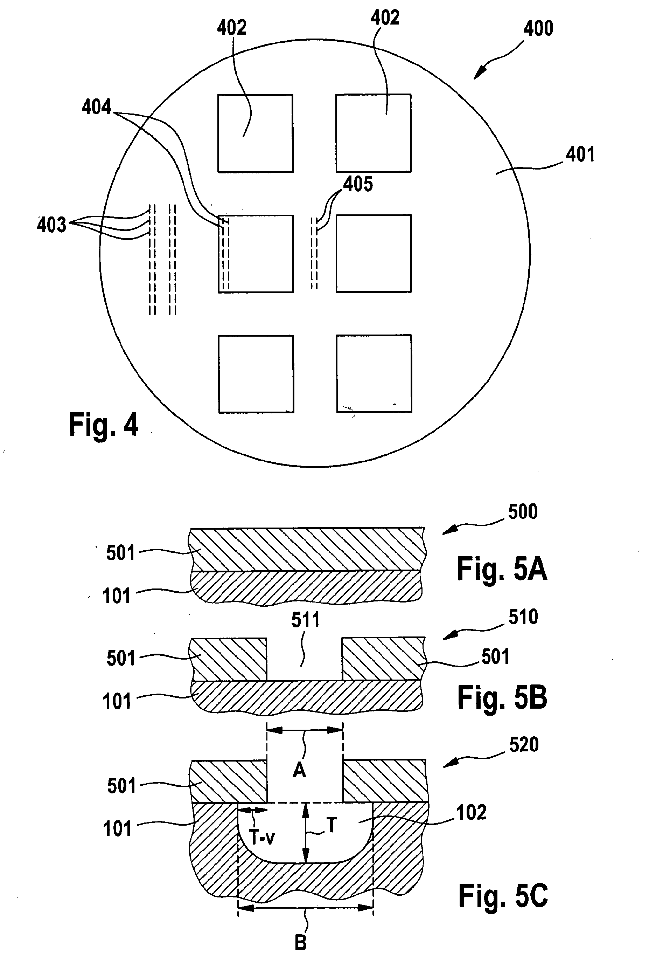

In the following, referring to **Fig. 4,** a product 400 according to an exemplary embodiment of the invention will be described.

The (semifinished) product 400 comprises a glass wafer 401 which is divided into a plurality of glass chips 402. Test structures 403 to 405 are formed on the wafer 401 or on the chips 402, respectively. Particularly, first test recesses 403 are formed in a peripheral region of the glass wafer 401 outside of the chips 402. Second test recesses 404 are formed on the chips 402, and third test recesses 405 are formed in a region between adjacent chips 402 of the glass wafer 401.

Providing test recesses 403 in unused portions of the glass wafer 401, as the first and the third test recesses 403, 405, those unused portions may be used according to the invention to verify the geometrical arrangement and/or alignment of a manufacturing process. By forming test recesses 404 directly on the chips 402, it may be verified, for instance after having separated the chips 402 from the wafer 401, individual problems which may occur also from the manufacturing process, for the different chips 402. When numbering the chips 402 or when providing another means allowing to unambiguously assign a chip 402 to a particular position on a wafer 401, location-specific problems during the manufacture process on various wafers 401 may be detected.

In the following, referring to Fig. 5A to Fig. 5C, different cross sections of layer sequences according to a method of manufacturing the test recesses 102 shown in Fig. 1 will be described according to an exemplary embodiment of the invention.

In a first method step, as shown in **Fig. 5A,** a layer sequence 500 is formed by depositing a layer of photoresist 501 on the glass substrate 501. Subsequently, the structure 500 shown in Fig. 5A is exposed to an illumination of particular portions of the photoresist layer 501 with light directed through a reticle (not shown in Fig. 5A).

After that, an etching step is performed in order to remove illuminated portions of the photoresist layer 501, thus obtaining the layer sequence 510 shown in **Fig. 5B** having trenches 511 at the positions at which the photoresist layer 501 has been removed by etching.

Subsequently, the layer sequence 510 is exposed to a further etching process, by which material of the glass substrate 501 which is uncovered by photoresist 501 is removed in order to form the test recesses 102. Although not shown in **Fig. 5C,** the layer sequence 520 is then exposed to a further etching process by which the remaining portions of the photoresist 101 are removed. As a result, the glass substrate 101 is uncovered with test recesses 102 provided therein.

However, as can be seen in Fig. 5C schematically, due to underetching effects, the width B of the test recesses 102 may be larger than the width A of the trenches 511 etched in the photoresist layer 501. The depth of the test recesses 102 is denoted with T, and the broadening at both end portions of the test recesses 102 is denoted with Tv, wherein v is the etching rate.

Thus, the relation between the parameters shown in Fig. 5C is:

$$B = A + 2Tv \qquad (1)$$

$$T = (B - A)/(2v) \qquad (2)$$

Equation (2) allows to indirectly calculate the depth T of the test recesses 102 from the optically inspectable width B and the process parameters A and v.

In the following, referring to Fig. 6A und Fig. 6B, it will be described how the underetching broadening can be used to determine the width of the test recesses 102.

**Fig. 6A** shows a plan view of a plurality of uncovered portions 600 formed in the photoresist layer 501 when illuminating the photoresist layer 501 by means of a mask (not shown) and by removing illuminated portions of the photoresist layer 501 by a first etching step.

**Fig. 6B** shows a plan view of the structure of Fig. 6A after having broadened the test recesses 102 in the glass substrate 101 by underetching, and after having removed the remaining part of the photoresist layer 501.

As can be seen in Fig. 6B, due to the underetching broadening effect, the test recesses 102 are formed by a central portion having the thickness of the uncovered portions 600 plus two adjacent portions 601 resulting from the underetching broadening.

As can further be taken from Fig. 6A and Fig. 6B, three rows of test recesses 102 are shown which are provided at different distances from one another. An upper row has a first distance, a middle row has a second distance smaller than the first distance, and a lower row has a third distance smaller than the second distance. Due to the different distances, the etching broadening has different effects on the three rows: The upper row consists, even after underetching, of two separated test recesses 102. In the middle row, the test recesses 102 are almost adjacent to one another, since the underetching broadening has removed almost all material which had been provided between the two test recesses 102. In the lower row, the underetching effect has connected the two test recesses 102 so that no material remains between the two adjacent test recesses 102 so that these two test recesses 102 are connected.

Thus, an optical inspection of the underetching broadening shown in Fig. 6B allows to derive the width of the test recesses 102 after underetching. Such an estimation may be supported by the knowledge of the geometrical properties of the test recesses 102 before underetching, that is to say the distance between the structure 600 of Fig. 6A in each row.

In the following, referring to **Fig. 7,** it will be explained as to how to derive information concerning the width and the depth of the test recesses 102 and therefore of the channels 104 of the product 100 shown in Fig. 1.

Fig. 7 again shows a detailed portion of the product 100, namely the portion in which the test recesses 102 are provided.

It is recalled that the test recesses 102 are paired to groups of parallel aligned test recesses 102, as shown in Fig. 7. Each of the pairs of test recesses 102 comprises two elongated holes arranged essentially parallel to each other, wherein the distance between the different test recesses 102 of the different pairs differs. As shown in Fig. 7, distance marks 701 are provided.

**Fig. 8** shows a detailed view of a portion 700 of the structure illustrated in Fig. 7.

Due to an underetching process, the test recesses 102 have been broadened, and due to the incremental arrangement of the test recesses 102, for some of the pairs of test recesses 102, the barrier between these test recesses 102 has been removed (see left pair of test recesses 102 of Fig. 8). For an another pair of test recesses 102, the distance has been bypassed so that the two corresponding test recesses 102 are now connected (see right hand pair of test recesses 102 in Fig. 8). However, in a central portion of Fig. 8, two test recesses 102 are shown which have just been connected/are still unconnected, so that the indication "13" in Fig. 7 is indicative of the width of the test recesses 102, as will be explained in the following.

Fig. 7 and Fig. 8 show a double stripe structure with an incremental increase of the distance by twice the etching depth. After etching the structures, the picture shown in Fig. 8 is obtained, based on which the achieved channel width can be estimated.

As can be seen in Fig. 8, the structure on the right hand side of the "13" has been overetched, that is to say the channels 102 are broader than the value of the structure. At the left hand side of the "13", there is still a barrier visible, that is to say this value of the channel width 102 has not already been obtained. Thus, the value is between those two values. When the increments have a value of 0.25 $\mu$m, it is possible to say that the two channels 102 have been etched to a width of the mask width plus two times 13$\mu$m, with an accuracy of +/- 0.25$\mu$m.

**Fig. 9** shows a plan view of the products 100, 200, more particular of an upper right portion of these two products 100, 200 after having bonded the product 100 to the product 200.

As can be seen, the circular channel 105 has been brought in alignment with the alignment markers 205 so that it can be verified quantitatively that the arrangement between the product 100 and the product 200 is properly adjusted.

Fig. 9 shows a crossing 900 which may be provided in addition to the alignment markers 105 on the first product 100. As can be seen, the crossing 900 and the circular channel 105 are brought in alignment with the alignment markers 205. The distance of the different alignment markers 205 from one another is 10 $\mu$m.

When the circle 105 is not symmetrically to the structure of the alignment markers 205, the misalignment can be visually recognized by means of the alignment markers 205, in a quantitative manner. For the distance of the alignment markers 205 with respect to each other, at least one fourth of the specified accuracy for the alignment process may be selected.

As shown in **Fig. 10A,** as an alternative to the parallel arrangement of oblong holes 102 shown in Fig. 1, it is also possible to use two circular concentric portions 1000 spaced at a predetermined distance 1001 from one another. By underetching, it can be optically recognized when the circular rings 1000 have been bridged by underetching portions 1010.

As a further alternative, as shown in **Fig. 10B,** test structures can be realized as two eccentric circles 1050 arranged at a predetermined distance from one another, wherein this distance can be bridged by an underetching portion 1051.

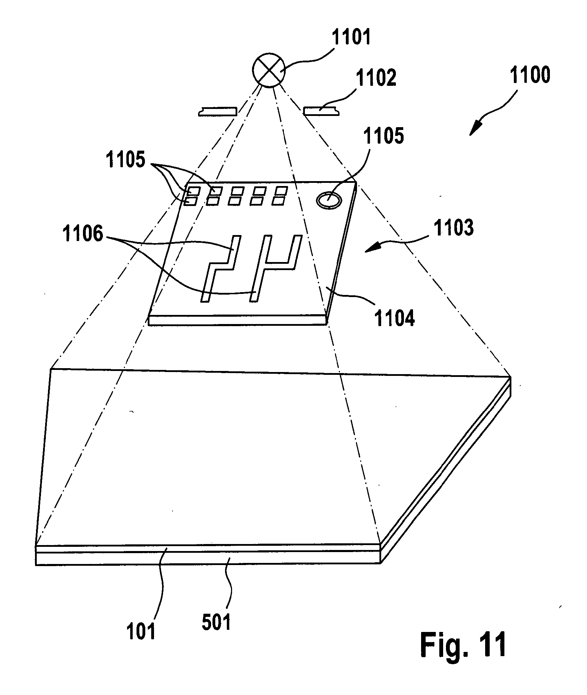

In the following, referring to **Fig. 11,** a lithography apparatus 1100 including a reticle 1103 according to an exemplary embodiment of the invention will be described.

For forming test structures 102, 105 and functional structures 104 in the product 100 (see Fig. 1), a lithography process and an etching process may be implemented.

Fig. 11 illustrates the optical lithography apparatus 1100 comprising a light source 1101, an aperture 1102, the reticle 1103 and the substrate 101 covered with a layer of photoresist 501. The light source 1101 emits light which passes through the aperture 1102 as well as test features 1105 and functional features 1106 which are provided as transparent portions of the opaque reticle 1103. Light transmitted through the test features 1105 and functional features 1106 impinges on the layer of photoresist 501. Thus, the arrangement of the test features 1105 and functional features 1106 are mapped to corresponding positions on the photoresist 501 covered substrate 101.

The reticle 1103 comprises a base member 1104, the plurality of test features 1105 formed in and/or on the base member 1104, and the plurality of functional features 1106 formed in and/or on the base member 1104. The test features 1105 are positioned in such a predefined spatial relation with respect to each other to be indicative of the geometrical properties of test structures 102, 105 of a product 100 formed based on the illuminated substrate 101 covered by the photoresist 501 by means of etching. After having performed an etching step to remove illuminated portions of the photoresist 101 and after having removed material of the partially uncovered substrate 101 by etching, similarly as described referring to Fig. 5A to Fig. 5C, the product 100 may be readily manufactured.

It should be noted that the term "comprising" does not exclude other elements or steps and the "a" or "an" does not exclude a plurality. Also elements described in association with different embodiments may be combined. It should also be noted that reference signs in the claims shall not be construed as limiting the scope of the claims.

**Claims**

1. A product (100), comprising
   a substrate (101);
   a plurality of test structures (102) formed in and/or on a surface (103) of the substrate (101);
   wherein the test structures (102) are positioned in such a predefined spatial relation with respect to each other to be indicative of the geometrical properties of the product (100).

2. The product (100) of claim 1, comprising at least one of the following features:

   the test structures (102) are positioned in such a predefined spatial relation with respect to each other to be quantitatively indicative of the geometrical properties of the product (100);
   the test structures (102) are test recesses;
   the substrate (101) is a glass substrate or a semiconductor substrate;
   the substrate (101) is a wafer or a chip;
   the substrate is a wafer (401) being divided into a plurality of chips (402), and the test structures (403 to 405) are formed in and/or on at least one of the group consisting of a peripheral region of the wafer (401) outside of the chips (402), a region between adjacent chips (402), and the chips (402).

3. The product (100) of claim 1 or any one of the above claims,
   comprising functional structures (104) formed in and/or on the surface (103) of the substrate (101), wherein the functional structures (104) are adapted to provide a function of the product (100).

4. The product (100) of claim 3, comprising at least one of the following features:

   the functional structures (104) are adapted as channels of a fluid separation device;
   the functional structures (104) are adapted as channels of a fluid separation device, wherein the fluid separation device is a gel electrophoresis device or a liquid chromatography device;
   the functional structures (104) are functional recesses.

5. The product (100) of claim 1 or any one of the above claims, comprising at least one of the following features:

   the test structures (102) are positioned in such a predefined spatial relation with respect to each other to be indicative of the width and/or of the depth of the test structures (102);
   the test structures (102) are grouped so that in different groups the corresponding test structures (102) have different distances from each other;
   the test structures (102) are grouped so that, in adjacent groups, the corresponding test structures (102) have varying distances from each other;
   the test structures (102) are grouped so that, in adjacent groups, the corresponding test structures (102) have incremental distances from each other;
   the test structures (102) comprise at least one of the group consisting of essentially parallel aligned elongated holes, concentric circular rings, circles positioned at a distance from one another, concentric polygonal rings, and polygons positioned at a distance from one another;
   the substrate (101) is a microstructure substrate.

6. The product (100) of claim 1 or any one of the above claims, comprising at least one of the following features:

   the test structures (105) are positioned in such a predefined spatial relation with respect to each other to be indicative of an alignment between the substrate (101) and a further substrate (201) bonded with or to be bonded with the substrate (101);
   the test structures (105) are positioned in such a predefined spatial relation with respect to each other to be indicative of an alignment with further test structures (205) formed in a further substrate (201) bonded with or to be bonded with the substrate (101);
   the test structures (205) are groups of items arranged equidistantly from one another;
   the test structures (205) are groups of items arranged equidistantly from one another, wherein the items comprise at least one of the group consisting of elongated holes, circular rings, circles, and polygons;
   the test structures (105) are at least one of the group consisting of a circle, a polygon, and a crossing.

7. The product (100) of claim 1 or any one of the above claims, comprising at least one of the following features:

> the product (100) is adapted as a microfluidic product;
> the product (100) is one of the group consisting of a fluid separation product, a gel electrophoresis product or a liquid chromatography product.

8. A fluid separation system for separating compounds of a fluid, the fluid separation system comprising a separation unit adapted for separating compounds of the fluid;
wherein the separation unit comprises a product (100, 200) of claim 1 or any one of the above claims.

9. The fluid separation system of claim 23, comprising at least one of the following features:

> the fluid separation system comprises a fluid delivering unit for delivering the fluid;
> the fluid is insertable in the functional structures (104).

10. A system for inspecting a product (100), the system comprising
a structure forming unit for forming a plurality of test structures (102) in and/or on a surface (103) of a substrate (101) of the product (100) and for positioning the test structures (102) in a predefined spatial relation with respect to each other;
an inspection unit for inspecting the geometrical properties of the product (100) under consideration of the predefined spatial relation of the test structures (102).

11. A method of inspecting a product (100), the method comprising the steps of
forming a plurality of test structures (102) in and/or on a surface (103) of a substrate (101) of the product (100);
positioning the test structures (100) in a predefined spatial relation with respect to each other;
inspecting the geometrical properties of the product (100) under consideration of the predefined spatial relation.

12. The method of claim 11, comprising at least one of the following features:

> the method further comprises the step of etching or underetching the plurality of test structures (102);
> the method further comprises the step of forming functional structures (104) in and/or on the surface (103) of the substrate (101) simultaneously with forming the test structures (102), wherein the functional structures (104) are formed to provide a function of the product (100);
the method further comprises the step of inspecting the geometrical properties of the test structures (102) by means of a magnifier or a microscope;

13. A reticle (1103), comprising
a base member (1104);
a plurality of test features (1105) formed in and/or on the base member (1104);
wherein the test features (1105) are positioned in such a predefined spatial relation with respect to each other to be indicative of the geometrical properties of test structures (102, 105) of a product (100) of claim 1 or any one of the above claims manufactured by means of the reticle (1103).

**Amended claims in accordance with Rule 86(2) EPC.**

**1.** A product (100), comprising
a substrate (101);
a plurality of test structures (102) formed in and/or on a surface (103) of the substrate (101);
**characterized in that** the test structures (102) are positioned in such a predefined spatial relation with respect to each other to be indicative, by an optical inspection, of the geometrical properties of the product (100).

**2.** The product (100) of claim 1, comprising at least one of the following features:

> the test structures (102) are positioned in such a predefined spatial relation with respect to each other to be quantitatively indicative of the geometrical properties of the product (100);
> the test structures (102) are test recesses;
> the substrate (101) is a glass substrate or a semiconductor substrate;
> the substrate (101) is a wafer or a chip;
> the substrate is a wafer (401) being divided into a plurality of chips (402), and the test structures (403 to 405) are formed in and/or on at least one of the group consisting of a peripheral region of the wafer (401) outside of the chips (402), a region between adjacent chips (402), and the chips (402).

**3.** The product (100) of claim 1 or any one of the above claims,
comprising functional structures (104) formed in and/or on the surface (103) of the substrate (101), wherein the functional structures (104) are adapted to provide a function of the product (100).

**4.** The product (100) of claim 3, comprising at least one of the following features:

the functional structures (104) are adapted as channels of a fluid separation device;
the functional structures (104) are adapted as channels of a fluid separation device, wherein the fluid separation device is a gel electrophoresis device or a liquid chromatography device;
the functional structures (104) are functional recesses.

**5.** The product (100) of claim 1 or any one of the above claims, comprising at least one of the following features:

the test structures (102) are positioned in such a predefined spatial relation with respect to each other to be indicative of the width and/or of the depth of the test structures (102);
the test structures (102) are grouped so that in different groups the corresponding test structures (102) have different distances from each other;
the test structures (102) are grouped so that, in adjacent groups, the corresponding test structures (102) have varying distances from each other;
the test structures (102) are grouped so that, in adjacent groups, the corresponding test structures (102) have incremental distances from each other,
the test structures (102) comprise at least one of the group consisting of essentially parallel aligned elongated holes, concentric circular rings, circles positioned at a distance from one another, concentric polygonal rings, and polygons positioned at a distance from one another;
the substrate (101) is a microstructure substrate.

**6.** The product (100) of claim 1 or any one of the above claims, comprising at least one of the following features:

the test structures (105) are positioned in such a predefined spatial relation with respect to each other to be indicative of an alignment between the substrate (101) and a further substrate (201) bonded with or to be bonded with the substrate (101);
the test structures (105) are positioned in such a predefined spatial relation with respect to each other to be indicative of an alignment with further test structures (205) formed in a further substrate (201) bonded with or to be bonded with the substrate (101);
the test structures (205) are groups of items arranged equidistantly from one another;
the test structures (205) are groups of items arranged equidistantly from one another, wherein the items comprise at least one of the group consisting of elongated holes, circular rings, circles, and polygons;
the test structures (105) are at least one of the group consisting of a circle, a polygon, and a crossing.

**7.** The product (100) of claim 1 or any one of the above claims, comprising at least one of the following features:

the product (100) is adapted as a microfluidic product;
the product (100) is one of the group consisting of a fluid separation product, a gel electrophoresis product or a liquid chromatography product.

**8.** A fluid separation system for separating compounds of a fluid, the fluid separation system comprising
a separation unit adapted for separating compounds of the fluid;
wherein the separation unit comprises a product (100, 200) of claim 1 or any one of the above claims.

**9.** The fluid separation system of claim 23, comprising at least one of the following features:

the fluid separation system comprises a fluid delivering unit for delivering the fluid;
the fluid is insertable in the functional structures (104).

**10.** A system for inspecting a product (100), the system comprising
a structure forming unit for forming a plurality of test structures (102) in and/or on a surface (103) of a substrate (101) of the product (100) and for positioning the test structures (102) in a predefined spatial relation with respect to each other;
an optical inspection unit for optically inspecting the geometrical properties of the product (100) under consideration of the predefined spatial relation of the test structures (102).

**11.** A method of inspecting a product (100), the method comprising the steps of
forming a plurality of test structures (102) in and/or on a surface (103) of a substrate (101) of the product (100);
positioning the test structures (100) in a predefined spatial relation with respect to each other;
optically inspecting the geometrical properties of the product (100) under consideration of the predefined spatial relation.

**12.** The method of claim 11, comprising at least one of the following features:

the method further comprises the step of etching or underetching the plurality of test structures (102);
the method further comprises the step of forming functional structures (104) in and/or on the surface (103) of the substrate (101) simultaneously with forming the test structures (102), wherein the functional structures (104) are formed to provide a function of the product (100);
the method further comprises the step of inspecting the geometrical properties of the test structures (102) by means of a magnifier or a microscope;

**13.** A reticle (1103), comprising
a base member (1104);
a plurality of test features (1105) formed in and/or on the base member (1104);
wherein the test features (1105) are positioned in such a predefined spatial relation with respect to each other to be indicative, by an optical inspection, of the geometrical properties of test structures (102, 105) of a product (100) of claim 1 or any one of the above claims manufactured by means of the reticle (1103).

**Fig. 1**

**Fig. 2**

**Fig. 3**

402    402    400

404

405

403    401

**Fig. 4**

500

501

101    **Fig. 5A**

511    510

501    501

101    **Fig. 5B**

520

A

501    102

101    T

T-v

B    **Fig. 5C**

Fig. 6A

Fig. 6B

Fig. 7

Fig. 8

**Fig. 9**

**Fig. 10A**

**Fig. 10B**

Fig. 11

**European Patent Office**

**PARTIAL EUROPEAN SEARCH REPORT**

which under Rule 45 of the European Patent Convention shall be considered, for the purposes of subsequent proceedings, as the European search report

**Application Number**

EP 05 10 6029

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 6 750 152 B1 (CHRISTENSON JOHN CARL ET AL) 15 June 2004 (2004-06-15)<br>* column 3, line 45 - line 52 *<br>* column 6, line 17 - line 20 *<br>* figures 2-4 *<br>----- | 1-5,7,8, 10-13 | INV.<br>B81C5/00 |

TECHNICAL FIELDS SEARCHED (IPC)

B81C

## INCOMPLETE SEARCH

The Search Division considers that the present application, or one or more of its claims, does/do not comply with the EPC to such an extent that a meaningful search into the state of the art cannot be carried out, or can only be carried out partially, for these claims.

Claims searched completely :

Claims searched incompletely :

Claims not searched :

Reason for the limitation of the search:

see sheet C

| Place of search | Date of completion of the search | Examiner |
|---|---|---|
| Berlin | 6 October 2005 | Foussier, P |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C07)

**European Patent Office**

**INCOMPLETE SEARCH
SHEET C**

Application Number

EP 05 10 6029

```
Claim(s) not searched:
      9

Reason for the limitation of the search:

Claim 9 depends on claim 23. Claim 23 doesn't exist. The intended scope
of protection can not be determined.
```

European Patent
Office

## CLAIMS INCURRING FEES

The present European patent application comprised at the time of filing more than ten claims.

☐ Only part of the claims have been paid within the prescribed time limit. The present European search report has been drawn up for the first ten claims and for those claims for which claims fees have been paid, namely claim(s):

☐ No claims fees have been paid within the prescribed time limit. The present European search report has been drawn up for the first ten claims.

## LACK OF UNITY OF INVENTION

The Search Division considers that the present European patent application does not comply with the requirements of unity of invention and relates to several inventions or groups of inventions, namely:

see sheet B

☐ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☒ None of the further search fees have been paid within the fixed time limit. The present European search report has been drawn up for those parts of the European patent application which relate to the invention first mentioned in the claims, namely claims:

1-5,7-8,10-13

**European Patent Office**

**LACK OF UNITY OF INVENTION SHEET B**

Application Number

EP 05 10 6029

The Search Division considers that the present European patent application does not comply with the requirements of unity of invention and relates to several inventions or groups of inventions, namely:

1. claims: 1-5,7-8,10-13

   Product with test structures being either elongated holes, rings, circles or polygons

   ---

2. claim: 6

   Product with test structures positioned so as to be indicative of an alignment between two bonded substrates

   ---

## ANNEX TO THE EUROPEAN SEARCH REPORT
## ON EUROPEAN PATENT APPLICATION NO.

EP 05 10 6029

This annex lists the patent family members relating to the patent documents cited in the above-mentioned European search report.
The members are as contained in the European Patent Office EDP file on
The European Patent Office is in no way liable for these particulars which are merely given for the purpose of information.

06-10-2005

| Patent document cited in search report | Publication date | Patent family member(s) | Publication date |
|---|---|---|---|
| US 6750152 B1 | 15-06-2004 | NONE | |

EPO FORM P0459

For more details about this annex : see Official Journal of the European Patent Office, No. 12/82